(19) Europäisches Patentamt
European Patent Office
Office européen des brevets

(11) **EP 3 849 278 B1**

(12) **EUROPEAN PATENT SPECIFICATION**

(45) Date of publication and mention
of the grant of the patent:
**27.08.2025 Bulletin 2025/35**

(21) Application number: **19857088.9**

(22) Date of filing: **05.09.2019**

(51) International Patent Classification (IPC):
***H05B 6/68*** (2006.01)     ***H05B 6/66*** (2006.01)

(52) Cooperative Patent Classification (CPC):
**H05B 6/686; H05B 6/666;** Y02B 40/00

(86) International application number:
**PCT/JP2019/034935**

(87) International publication number:
**WO 2020/050356 (12.03.2020 Gazette 2020/11)**

(54) **RF ENERGY RADIATION DEVICE**

HF-ENERGIESTRAHLVORRICHTUNG

DISPOSITIF DE RAYONNEMENT D'ÉNERGIE RF

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.09.2018 JP 2018167408**

(43) Date of publication of application:
**14.07.2021 Bulletin 2021/28**

(60) Divisional application:
**23182475.6 / 4 243 572**

(73) Proprietor: **Panasonic Intellectual Property
Management Co., Ltd.
Osaka-shi, Osaka 540-6207 (JP)**

(72) Inventors:
• **TAKANO, Shinji
Osaka-shi, Osaka 540-6207 (JP)**
• **HIRAMOTO, Masayoshi
Osaka-shi, Osaka 540-6207 (JP)**

• **OGASAWARA, Fumitaka
Osaka-shi, Osaka 540-6207 (JP)**
• **IWATA, Motoyoshi
Osaka-shi, Osaka 540-6207 (JP)**
• **UNO, Takashi
Osaka-shi, Osaka 540-6207 (JP)**
• **FUKUI, Mikio
Osaka-shi, Osaka 540-6207 (JP)**
• **HOSOKAWA, Daisuke
Osaka-shi, Osaka 540-6207 (JP)**

(74) Representative: **SSM Sandmair
Patentanwälte Rechtsanwalt
Partnerschaft mbB
Joseph-Wild-Straße 20
81829 München (DE)**

(56) References cited:
WO-A1-2015/099649    JP-A- 2004 309 026
JP-A- 2004 309 026    JP-A- 2007 335 375
JP-A- 2017 504 158    JP-A- 2017 504 158
JP-A- H0 434 890    US-A1- 2018 226 949

## Description

### TECHNICAL FIELD

The present disclosure relates to an RF energy radiation device with improved reliability.

### BACKGROUND ART

Radio frequency (RF) energy radiation devices such as microwave ovens known in the art detect reflected power, adjust output power in accordance with the magnitude of the reflected power, and stop output if the magnitude of the reflected power is equal to or higher than a threshold. This is how the RF energy radiation devices known in the art protect themselves (see, for example, Patent Literature 1). Patent Literature 2 discloses a technique for detecting not only reflected power but also high-frequency current, thereby improving the protection of the devices.

FIG. 7 shows an RF energy radiation device described in Patent Literature 1. As shown in FIG. 7, this RF energy radiation device includes magnetron 1, control unit 6, and detection unit 5.

Control unit 6 controls drive unit 7. When drive unit 7 supplies power to magnetron 1, magnetron 1 generates a microwave. Waveguide 2 transmits the microwave to power supply unit 4. Power supply unit 4 radiates the microwave into cavity 3.

Detection unit 5 detects the reflected power that returns to waveguide 2 from cavity 3 via power supply unit 4. Control unit 6 controls drive unit 7 based on the reflected power detected by detection unit 5.

WO 2015/099649 A1 (WHIRLPOOL CO [US]) 2 July 2015 (2015-07-02); & JP 2017 504158 A 2 February 2017 (2017-02-02) describes an interrupting circuit which is configured to monitor for and detect a fault in a device.

Citation List

Patent Literature

> PTL 1: Japanese Unexamined Patent Application Publication No. 4-245191
> PTL 2: Japanese Unexamined Patent Application Publication No. 2-087929

### SUMMARY OF THE INVENTION

In the RF energy radiation device known in the art, 30% to 50% of energy consumption is radiated as heat due to the energy efficiency of the semiconductor amplifier. This energy efficiency varies depending on load or ambient temperature, so that the amount of heat to be released also varies. The relation between the heat and the efficiency is a significant issue in using the semiconductor amplifier. The termination that receives and absorbs reflected power generates heat. Therefore, detecting reflected power and high-frequency current alone is not necessarily enough to protect the device effectively.

An object of the present disclosure, which solves the above-described problem, is to provide a reliable RF energy radiation device.

The RF energy radiation device according to the present invention is defined by claim 1.

The RF energy radiation device monitors the temperatures of the heat-generating components. This enables adjusting the RF energy and radiating the RF energy efficiency to a heating target object. This also enables detecting a mounting failure and stopping the device immediately. Hence, the device has higher reliability.

### BRIEF DESCRIPTION OF DRAWINGS

> FIG. 1 is a block diagram of the structure of an RF energy radiation device according to an exemplary embodiment of the present disclosure.
> FIG. 2 is a block diagram of the structure of a power amplifier in the exemplary embodiment.
> FIG. 3 shows the operation sequence of the RF energy radiation device according to the exemplary embodiment.
> FIG. 4 is a graph showing two temperature-rise straight lines of a heating target object in the exemplary embodiment.
> FIG. 5 is a sectional view of a mounting structure of a temperature sensor.
> FIG. 6 is a sectional view of another mounting structure of the temperature sensor.

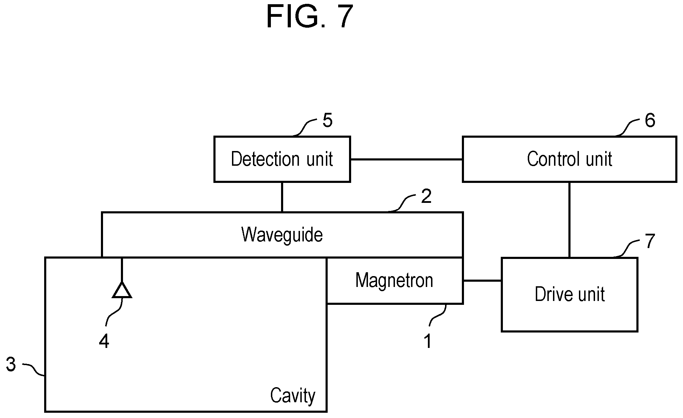

FIG. 7 is a block diagram of the structure of an RF energy radiation device known in the art.

**DESCRIPTION OF EMBODIMENTS**

An RF energy radiation device according to a first aspect of the present disclosure includes the following components: a cavity in which a heating target object is to be placed, an RF signal generation unit, an RF amplifier, a radiation element, a temperature sensor, and a controller. The RF signal generation unit oscillates an RF signal. The RF amplifier amplifies the RF signal to provide RF energy. The radiation element radiates the RF energy into the cavity. The temperature sensor is disposed in the vicinity of the RF amplifier. The controller causes the RF amplifier to adjust the output of the RF energy in accordance with the temperature detected by the temperature sensor and a plurality of threshold levels.

In an RF energy radiation device according to a second aspect of the present disclosure, in addition to the first aspect, when the temperature detected by the temperature sensor exceeds one of the plurality of threshold levels, the controller causes the RF amplifier to adjust the output value of the RF energy in accordance with the temperature that exceeds the one of the plurality of threshold levels.

In an RF energy radiation device according to a third aspect of the present disclosure, in addition to the second aspect, when the temperature detected by the temperature sensor exceeds a different one of the plurality of threshold levels that is higher than the one of the plurality of threshold levels, the controller controls the RF amplifier so that the RF amplifier reduces the output value of the RF energy.

In an RF energy radiation device according to a fourth aspect of the present disclosure, in addition to the third aspect, the different one of the plurality of threshold levels varies depending on the rising rate of the temperature detected by the temperature sensor.

In an RF energy radiation device according to a fifth aspect of the present disclosure, in addition to the second aspect, when the temperature detected by the temperature sensor exceeds a different one of the plurality of threshold levels that is higher than the one of the plurality of threshold levels, the controller stops the RF signal generation unit.

In an RF energy radiation device according to a sixth aspect of the present disclosure, in addition to the first aspect, the plurality of threshold levels include a first threshold level, a second threshold level higher than the first threshold level, and a third threshold level higher than the second threshold level. When the temperature detected by the temperature sensor exceeds the first threshold level, the controller controls the RF amplifier so that the RF amplifier adjusts the output of the RF energy in accordance with the temperature that exceeds the first threshold level. When the temperature detected by the temperature sensor exceeds the second threshold level, the controller controls the RF amplifier so that the RF amplifier reduces the output of the RF energy. When the temperature detected by the temperature sensor exceeds the third threshold level, the controller stops the RF signal generation unit.

In an RF energy radiation device according to a seventh aspect of the present disclosure, in addition to the sixth aspect, the second threshold level varies depending on the rising rate of the temperature detected by the temperature sensor.

In an RF energy radiation device according to an eighth aspect of the present disclosure, in addition to the first aspect, the RF amplifier is included in a semiconductor device disposed on a substrate in such a manner that the bottom of the semiconductor device is in contact with a base plate. The temperature sensor is disposed on the side of the substrate opposite to the side on which the semiconductor device is disposed.

In an RF energy radiation device according to a ninth aspect of the present disclosure, in addition to the first aspect, the RF amplifier is included in a semiconductor device disposed on a substrate in such a manner that the bottom of the semiconductor device is in contact with a base plate. The temperature sensor is disposed on the same side of the substrate as the side on which the semiconductor device is disposed.

RF energy radiation device 100 according to an exemplary embodiment of the present disclosure will now be described with reference to the drawings.

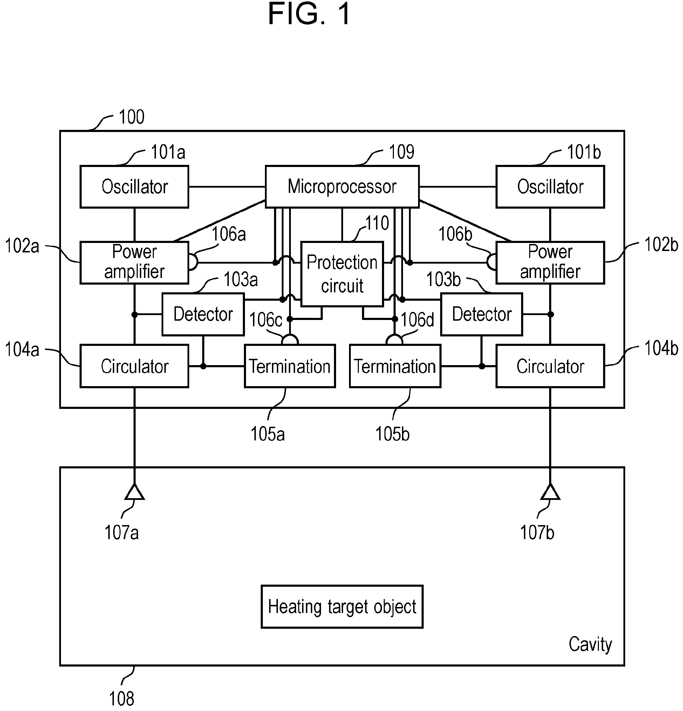

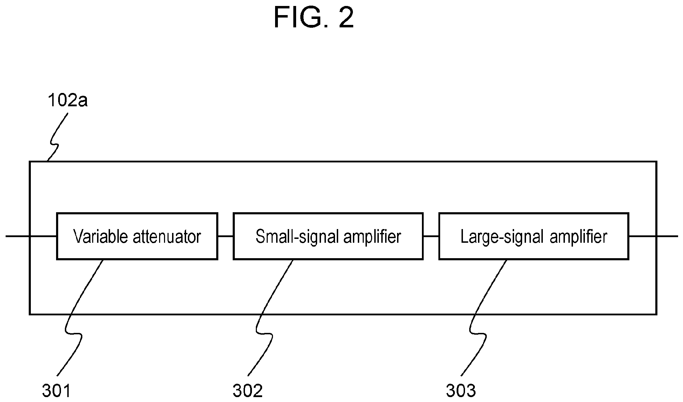

FIG. 1 is a block diagram of the structure of RF energy radiation device 100. FIG. 2 is a block diagram of the structure of power amplifier 102a. Power amplifiers 102a and 102b have the same structure, so that power amplifier 102a alone will be described in detail, leaving power amplifier 102b undescribed.

As shown in FIG. 1, RF energy radiation device 100 includes the following components: oscillators 101a and 101b, power amplifiers 102a and 102b, detectors 103a and 103b, circulators 104a and 104b, terminations 105a and 105b, radiation elements 107a and 107b, and cavity 108.

Oscillators 101a and 101b each oscillate an RF signal. Power amplifiers 102a and 102b amplify the RF signals oscillated by oscillators 101a and 101b, respectively, and each provide RF power. Detectors 103a and 103b detect the RF power transmitted from RF energy radiation device 100 toward radiation elements 107a and 107b, respectively. Detectors 103a and 103b further detect the RF power transmitted from radiation elements 107a and 107b, respectively, toward RF energy radiation device 100.

Oscillators 101a and 101b correspond to an RF signal generation unit, power amplifiers 102a and 102b correspond to an RF amplifier, and detectors 103a and 103b correspond to an RF power detection unit.

Hereinafter, the RF power transmitted from RF energy radiation device 100 toward radiation elements 107a and 107b will be referred to as a transmitted wave, whereas the RF power transmitted from elements 107a and 107b toward device 100 will be referred to as a reflected wave.

Circulator 104a transmits the transmitted wave coming from oscillator 101a to radiation element 107a, and transmits the reflected wave coming from radiation element 107a to termination 105a. Similarly, circulator 104b transmits the transmitted wave coming from oscillator 101b to radiation element 107b, and transmits the reflected wave coming from radiation element 107b to termination 105b.

Terminations 105a and 105b have respective impedances, which become the loads of the reflected waves received from circulators 104a and 104b, respectively.

Circulators 104a, 104b and terminations 105a, 105b protect oscillators 101a, 101b from the reflected waves caused due to a load fluctuation of a heating target object (e.g., food) when the object is placed in cavity 108. Radiation elements 107a and 107b radiate RF energy into cavity 108.

RF energy radiation device 100 further includes the following components: temperature sensors 106a, 106b, 106c, and 106d, microprocessor 109, and protection circuit 110.

Temperature sensors 106a and 106b are disposed near power amplifiers 102a and 102b, respectively, and temperature sensors 106c and 106d are disposed near terminations 105a and 105b, respectively. Microprocessor 109 is a controller for controlling RF energy radiation device 100 in accordance with the temperatures detected by temperature sensors 106a to 106d. Protection circuit 110 operates to protect RF energy radiation device 100 if at least one of the temperatures detected by temperature sensors 106a to 106d exceeds a predetermined value.

As shown in FIG. 2, power amplifier 102a includes variable attenuator 301, small-signal amplifier 302, and large-signal amplifier 303 (the same holds true for power amplifier 102b).

Variable attenuator 301 receives the RF signal from oscillator 101a and adjusts the attenuation amount of the RF signal. Small-signal amplifier 302 amplifies the signal outputted from variable attenuator 301 to some extent. Large-signal amplifier 303 amplifies the signal outputted from small-signal amplifier 302 to a desired output of the RF energy.

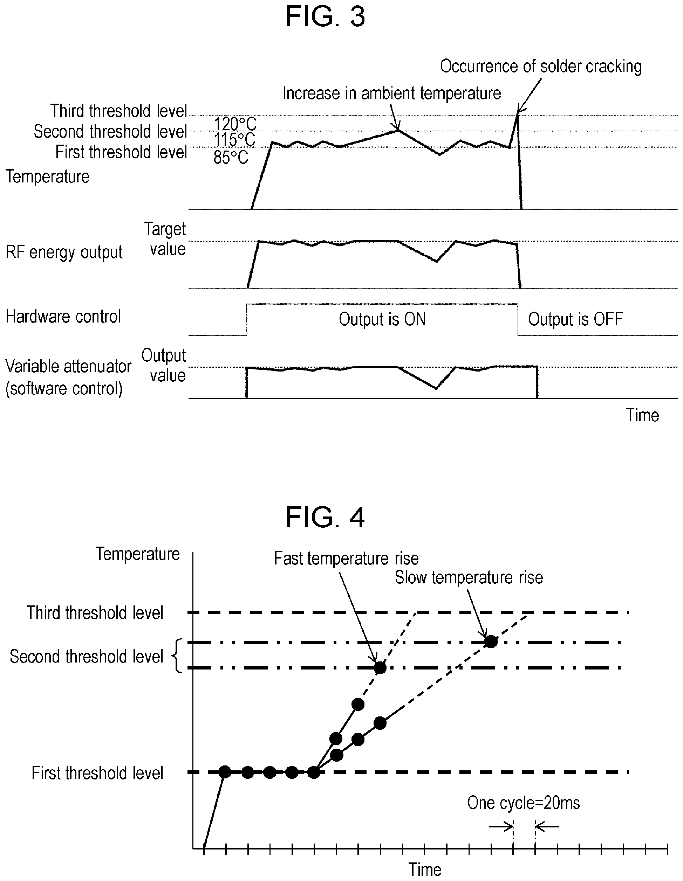

The operation and effects of RF energy radiation device 100 with the above-described structure will now be described with reference to FIGS. 3 and 4. FIG. 3 shows the operation sequence of RF energy radiation device 100. FIG. 4 is a graph showing two temperature-rise straight lines of the heating target object used in the present exemplary embodiment.

Microprocessor 109 causes oscillators 101a and 101b to oscillate an RF signal with an arbitrary frequency. Microprocessor 109 causes power amplifiers 102a and 102b to output RF energy of a target value. The RF energy output is adjusted to the target value by first adjusting the attenuation amount of variable attenuator 301.

Concerning the transmitted wave, microprocessor 109 adjusts the attenuation amount of variable attenuator 301 so that the RF energy amount is stable even during the operation of RF energy radiation device 100 in accordance with the power values detected by detectors 103a and 103b.

Concerning the reflected wave, microprocessor 109 controls power amplifiers 102a and 102b so that if at least one of the temperatures detected by temperature sensors 106a and 106b exceeds a first threshold level, the RF energy output can be reduced to reduce the radiation heat from the heat-generating components corresponding to the temperature exceeding the first threshold level.

If at least one of the power values detected by detectors 103a and 103b exceeds an allowable level, protection circuit 110 immediately stops RF energy radiation device 100 by mechanical means, thereby protecting device 100. Protection circuit 110 informs microprocessor 109 that RF energy radiation device 100 has been stopped.

Terminations 105a and 105b are heat-generating components that generate heat when receiving reflected waves. Terminations 105a and 105b have a large temperature rise.

The efficiency of large-signal amplifier 303 can be reduced by changes in the load due to changes in its physical properties during heating and an increase in ambient temperature of RF energy radiation device 100. As a result, large-signal amplifier 303 generates more heat, thereby increasing the temperatures detected by temperature sensors 106a and 106b.

Microprocessor 109 stores a first threshold level (e.g., 85°C), a second threshold level (e.g., 115°C), and a third threshold level (e.g., 120°C) shown in FIG. 3. Small-signal amplifier 302, which has a small output power, does not cause a large heat generation, resulting in small temperature rise. This means that the temperature rise in power amplifiers 102a and 102b is largely caused by large-signal amplifier 303.

If at least one of the temperatures detected by temperature sensors 106a and 106b exceeds the first threshold level, microprocessor 109 controls the attenuation amount D (dB) of variable attenuator 301 minutely using software control so that the RF energy output of power amplifiers 102a and 102b is reduced to reduce the radiation heat from the heat-generating components corresponding to the exceeded temperature. For example, the attenuation amount D can be calculated using semiconductor thermal resistance as shown in formula (1) shown below. This can prevent a temperature rise in power amplifiers 102a and 102b.

$$D = 10 \times \log_{10} P_{\text{det}} - 10 \times \log_{10} \left( P_{\text{det}} - P_{\text{down}} \right) \quad (1)$$

where

$P_{\text{det}}$ (W): the power value of transmitted wave

$P_{\text{down}}$ (W): (detected temperature (°C) - 85(°C)) $\times$ 1/Z

Z(°C/W): semiconductor thermal resistance between the junction and the case

If the ambient temperature increases greatly to exceed the second threshold level, microprocessor 109 causes variable attenuator 301 to reduce the RF energy output greatly, thereby reducing the temperature greatly.

FIG. 4 is a graph showing the second threshold level changes in accordance with the rising rate of the temperatures detected by temperature sensors 106a to 106d. When temperature rising rate is high as shown in FIG. 4, the temperature rise value in one cycle of the software control is large.

Therefore, the second threshold level is set lower when the temperature rising rate is high than when the temperature rising rate is low. This enables reducing the RF energy output before the temperature gets too high during one cycle of the software control.

The second threshold level is automatically set to a level capable of preventing the hardware from stopping the device, considering the rising rate of the temperatures detected by temperature sensors 106a to 106d and the response time (time lag) when the hardware stops RF energy output.

If any of the temperatures rises suddenly to exceed the third threshold level due to a mounting failure such as solder cracking, protection circuit 110 immediately stops RF energy radiation device 100 by using mechanical means, thereby protecting device 100.

As described above, according to the present exemplary embodiment, temperature sensors 106a and 106b are disposed near power amplifiers 102a and 102b, respectively, and temperature sensors 106c and 106d are disposed near terminations 105a and 105b, respectively. The temperatures of these heat-generating components are monitored to control the RF energy output, thereby reducing the temperature rise in power amplifiers 102a, 102b and terminations 105a, 105b. This results in extending the life of the device.

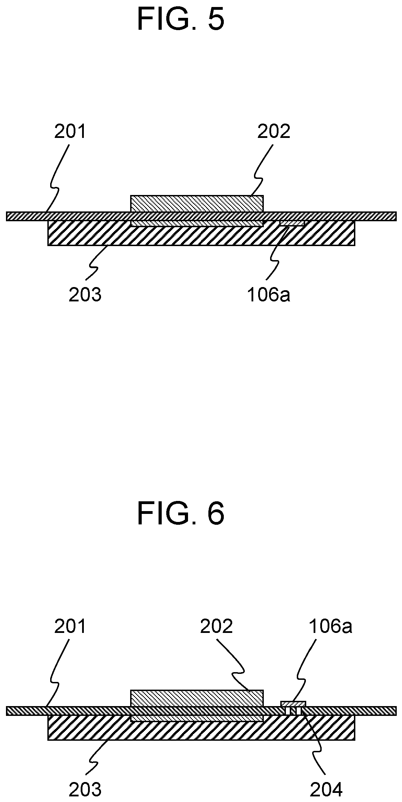

FIG. 5 is a sectional view of a mounting structure of temperature sensor 106a.

The mounting structure of temperature sensor 106a will now be described as follows. The mounting structure of temperature sensors 106b to 106d will be omitted because it is the same as that of temperature sensor 106a.

As shown in FIG. 5, in this mounting structure, semiconductor device 202 including large-signal amplifier 303 is disposed on substrate 201 in such a manner that the bottom of semiconductor device 202 is in contact with base plate 203. Temperature sensor 106a is disposed on the side of substrate 201 opposite to the side on which semiconductor device 202 is disposed.

Temperature sensor 106a is disposed on the solder side of substrate 201 so as to be in contact with base plate 203 made of a thermally conductive material such as copper or aluminum. More specifically, temperature sensor 106a is disposed in an area with a low thermal resistance between the bottom of semiconductor device 202, which is a heat-generating component, and temperature sensor 106a.

This mounting structure enables detecting approximately the actual temperatures of the heat-generating components, and correcting the detected temperature easily because of the low thermal resistance. Thus, the temperatures can be detected with high precision and high response.

FIG. 6 is a sectional view of another mounting structure of temperature sensor 106a. As shown in FIG. 6, in this mounting structure, similar to the mounting structure of FIG. 5, semiconductor device 202 including large-signal amplifier 303 is disposed on substrate 201 in such a manner that the bottom of semiconductor device 202 is in contact with base plate 203. Unlike the mounting structure shown in FIG. 5, temperature sensor 106a is disposed on the same side of substrate 201 as the side on which semiconductor device 202 is disposed. Substrate 201 has through-hole 204 near semiconductor device 202.

This mounting structure enables, in the same manner as the mounting structure shown in FIG. 5, detecting approximately the actual temperatures of the heat-generating components, thereby precisely controlling RF energy radiation device 100.

## INDUSTRIAL APPLICABILITY

The RF energy radiation device according to the present disclosure is applicable to thawing apparatuses, heating cookers, dryers, etc.

**REFERENCE MARKS IN THE DRAWINGS**

100 RF energy radiation device
101a, 101b oscillator
102a, 102b power amplifier
103a, 103b detector
104a, 104b circulator
105a, 105b termination
106a, 106b, 106c, 106d temperature sensor
107a, 107b radiation element
108 cavity
109 microprocessor
110 protection circuit
201 substrate
202 semiconductor device
203 base plate
204 through-hole
301 variable attenuator
302 small-signal amplifier
303 large-signal amplifier

**Claims**

1. A radio frequency, RF, energy radiation device (100) comprising:

   a cavity (108) in which a heating target object is to be placed;
   an RF signal generation unit (101) configured to oscillate an RF signal;
   an RF amplifier (102) configured to amplify the RF signal to provide RF energy;
   a radiation element (107) configured to radiate the RF energy into the cavity (108);
   a temperature sensor (106) disposed in a vicinity of the RF amplifier (102); and
   a controller (109) configured to cause the RF amplifier (102) to adjust an output value of the RF energy in accordance with a temperature detected by the temperature sensor (106) and a plurality of threshold levels, wherein when the temperature detected by the temperature sensor /106) exceeds one of the plurality of threshold levels, the controller (109) causes the RF amplifier (102) to adjust the output value of the RF energy in accordance with the temperature that exceeds the one of the plurality of threshold levels, and
   **characterised in that** a different one of the plurality of threshold levels is higher than the one of the plurality of threshold levels, and the different one of the plurality of threshold levels varies depending on a rising rate of the temperature detected by the temperature sensor (106).

2. The RF energy radiation device (100) according to claim 1, wherein when the temperature detected by the temperature sensor (106) exceeds the different one of the plurality of threshold levels, the controller (109) causes the RF amplifier (102) to reduce the output value of the RF energy.

3. The RF energy radiation device (100) according to claim 1, wherein when the temperature detected by the temperature sensor (106) exceeds a different one of the plurality of threshold levels that is higher than the one of the plurality of threshold levels, the controller (109) stops the RF signal generation unit (101).

4. The RF energy radiation device (100) according to claim 1, wherein the plurality of threshold levels comprise:

   a first threshold level,
   a second threshold level higher than the first threshold level, and
   a third threshold level higher than the second threshold level,

   wherein

when the temperature detected by the temperature sensor (106) exceeds the first threshold level, the controller (109) causes the RF amplifier (102) to adjust an output of the RF energy in accordance with the temperature that exceeds the first threshold level,

when the temperature detected by the temperature sensor (106) exceeds the second threshold level, the controller (109) causes the RF amplifier (102) to reduce the output of the RF energy, and

when the temperature detected by the temperature sensor (106) exceeds the third threshold level, the controller (109) stops the RF signal generation unit (101).

5. The RF energy radiation device (100) according to claim 4, wherein the second threshold level varies depending on a rising rate of the temperature detected by the temperature sensor (106).

6. The RF energy radiation device (100) according to claim 1, wherein

the RF amplifier (102) is included in a semiconductor device (202) disposed on a substrate (201) in such a manner that a bottom of the semiconductor device (202) is in contact with a base plate (203), and
the temperature sensor (106) is disposed on a side of the substrate (201) opposite to a side on which the semiconductor device (202) is disposed.

7. The RF energy radiation device (100) according to claim 1, wherein

the RF amplifier (102) is included in a semiconductor device (202) disposed on a substrate (201) in such a manner that a bottom of the semiconductor device (202) is in contact with a base plate (203), and
the temperature sensor (106) is disposed on a same side of the substrate (201) as a side on which the semiconductor device (202) is disposed.

**Patentansprüche**

1. Eine Radiofrequenz, RF, Energienstrahlungsvorrichtung (100), umfassend:

einen Hohlraum (108), in dem ein zu erwärmendes Zielobjekt angeordnet werden soll;
eine RF-Signalerzeugungseinheit (101), die dazu eingerichtet ist, ein RF-Signal zu oszillieren;
einen RF-Verstärker (102), der dazu eingerichtet ist, das RF-Signal zu verstärken, um RF-Energie bereitzustellen;
ein Strahlungselement (107), das dazu eingerichtet ist, die RF-Energie in den Hohlraum (108) zu strahlen;
einen Temperatursensor (106), der in der Nähe des RF-Verstärkers (102) angeordnet ist; und
eine Steuereinrichtung (109), die dazu eingerichtet ist, den RF-Verstärker (102) zu veranlassen, einen Ausgangswert der RF-Energie entsprechend einer vom Temperatursensor (106) erfassten Temperatur und mehreren Schwellenwerten anzupassen,
wobei, wenn die vom Temperatursensor (106) erfasste Temperatur einen der mehreren Schwellenwerte überschreitet, die Steuereinrichtung (109) den RF-Verstärker (102) veranlasst, den Ausgangswert der RF-Energie entsprechend der Temperatur, die den einen der mehreren Schwellenwerte überschreitet, anzupassen, und
**dadurch gekennzeichnet, dass**
ein anderer der mehreren Schwellenwerte höher ist als der eine der mehreren Schwellenwerte, und der andere der mehreren Schwellenwerte in Abhängigkeit von einer Anstiegsrate der vom Temperatursensor (106) erfassten Temperatur variiert.

2. Die RF-Energiestrahlungsvorrichtung (100) nach Anspruch 1, wobei, wenn die vom Temperatursensor (106) erfasste Temperatur den anderen der mehreren Schwellenwerte überschreitet, die Steuereinheit (109) den RF-Verstärker (102) veranlasst, den Ausgangswert der RF-Energie zu verringern.

3. Die RF-Energiestrahlungsvorrichtung (100) nach Anspruch 1, wobei, wenn die vom Temperatursensor (106) erfasste Temperatur einen anderen der mehreren Schwellenwerte überschreitet, der größer ist als der eine der mehreren Schwellenwerte, die Steuereinheit (109) die RF-Signalerzeugungseinheit (101) stoppt.

4. Die RF-Energiestrahlungsvorrichtung (100) nach Anspruch 1, wobei die mehreren Schwellenwerte umfassen:

einen ersten Schwellenwert,

einen zweiten Schwellenwert, der größer ist als der erste Schwellenwert, und
einen dritten Schwellenwert, der größer ist als der zweite Schwellenwert,
wobei
wenn die vom Temperatursensor (106) erfasste Temperatur den ersten Schwellenwert überschreitet, die Steuereinheit (109) bewirkt, dass der RF-Verstärker (102) eine Ausgabe der RF-Energie entsprechend der Temperatur, die den ersten Schwellenwert überschreitet, anpasst,
wenn die vom Temperatursensor (106) erfasste Temperatur den zweiten Schwellenwert überschreitet, die Steuereinheit (109) den RF-Verstärker (102) veranlasst, die RF-Energieabgabe zu verringern, und
wenn die vom Temperatursensor (106) erfasste Temperatur den dritten Schwellenwert überschreitet, die Steuereinheit (109) die RF-Signalerzeugungseinheit (101) stoppt.

**5.** Die RF-Energiestrahlungsvorrichtung (100) gemäß Anspruch 4, wobei der zweite Schwellenwert in Abhängigkeit von einer Anstiegsrate der vom Temperatursensor (106) erfassten Temperatur variiert.

**6.** Die RF-Energiestrahlungsvorrichtung (100) gemäß Anspruch 1, wobei

der RF-Verstärker (102) in einer Halbleitervorrichtung (202) enthalten ist, die auf einem Substrat (201) so angeordnet ist, dass eine Unterseite der Halbleitervorrichtung (202) mit einer Grundplatte (203) in Kontakt steht, und
der Temperatursensor (106) auf einer Seite des Substrats (201) gegenüber einer Seite angeordnet ist, auf der die Halbleitervorrichtung (202) angeordnet ist.

**7.** Die RF-Energiestrahlungsvorrichtung (100) gemäß Anspruch 1, wobei

der RF-Verstärker (102) in einer Halbleitervorrichtung (202) enthalten ist, die auf einem Substrat (201) so angeordnet ist, dass eine Unterseite der Halbleitervorrichtung (202) mit einer Grundplatte (203) in Kontakt steht, und
der Temperatursensor (106) auf derselben Seite des Substrats (201) angeordnet ist wie die Seite, auf der die Halbleitervorrichtung (202) angeordnet ist.

## Revendications

**1.** Dispositif de rayonnement d'énergie radiofréquence (RF) (100) comprenant :

une cavité (108) dans laquelle un objet à chauffer est destiné à être placé,
une unité de génération de signal RF (101) conçue pour faire osciller un signal RF,
un amplificateur RF (102) conçu pour amplifier le signal RF afin de fournir de l'énergie RF,
un élément de rayonnement (107) conçu pour rayonner de l'énergie RF dans la cavité (108),
un capteur de température (106) disposé à proximité de l'amplificateur RF (102), et
un dispositif de commande (109) conçu pour amener l'amplificateur RF (102) à ajuster la valeur de sortie de l'énergie RF en fonction de la température détectée par le capteur de température (106) et d'une pluralité de niveaux seuils ;
étant entendu que, lorsque la température détectée par le capteur de température (106) dépasse un desdits niveaux seuils, le dispositif de commande (109) amène l'amplificateur RF (102) à ajuster la valeur de sortie de l'énergie RF en fonction de ladite température dépassant ledit niveau seuil ;
**caractérisé en ce qu'**un niveau dit différent de la pluralité de niveaux seuils est plus élevé que ledit niveau de la pluralité de niveaux seuils, et ledit niveau différent de la pluralité de niveaux seuils varie en fonction de la vitesse d'augmentation de la température détectée par le capteur de température (106).

**2.** Dispositif de rayonnement d'énergie RF (100) selon la revendication 1, dans lequel, lorsque la température détectée par le capteur de température (106) dépasse ledit niveau différent de la pluralité de niveaux seuils, le dispositif de commande (109) amène l'amplificateur RF (102) à réduire la valeur de sortie de l'énergie RF.

**3.** Dispositif de rayonnement d'énergie RF (100) selon la revendication 1, dans lequel, lorsque la température détectée par le capteur de température (106) dépasse un niveau dit différent de la pluralité de niveaux seuils qui est supérieur audit niveau seuil de la pluralité de niveaux seuils, le dispositif de commande (109) arrête l'unité de génération de signal RF (101).

**4.** Dispositif de rayonnement d'énergie RF (100) selon la revendication 1, dans lequel la pluralité de niveaux seuils comprend :

un premier niveau seuil,
un deuxième niveau seuil supérieur au premier niveau seuil, et
un troisième niveau seuil supérieur au deuxième niveau seuil ;
étant entendu que
lorsque la température détectée par le capteur de température (106) dépasse le premier niveau seuil, le dispositif de commande (109) amène l'amplificateur RF (102) à ajuster la sortie de l'énergie RF en fonction de ladite température dépassant le premier niveau seuil,
lorsque la température détectée par le capteur de température (106) dépasse le deuxième niveau seuil, le dispositif de commande (109) amène l'amplificateur RF (102) à réduire la sortie de l'énergie RF, et
lorsque la température détectée par le capteur de température (106) dépasse le troisième niveau seuil, le dispositif de commande (109) arrête l'unité de génération de signal RF (101).

**5.** Dispositif de rayonnement d'énergie RF (100) selon la revendication 4, dans lequel le deuxième niveau seuil varie en fonction de la vitesse d'augmentation de la température détectée par le capteur de température (106).

**6.** Dispositif de rayonnement d'énergie RF (100) selon la revendication 1, dans lequel

l'amplificateur RF (102) est compris dans un dispositif semi-conducteur (202) disposé sur un substrat (201) de telle façon que le dessous du dispositif semi-conducteur (202) est en contact avec une plaque de base (203), et le capteur de température (106) est disposé sur une face du substrat (201) opposée à une face sur laquelle est disposé le dispositif semi-conducteur (202).

**7.** Dispositif de rayonnement d'énergie RF (100) selon la revendication 1, dans lequel

l'amplificateur RF (102) est compris dans un dispositif semi-conducteur (202) disposé sur un substrat (201) de telle façon que le dessous du dispositif semi-conducteur (202) est en contact avec une plaque de base (203), et le capteur de température (106) est disposé sur la même face du substrat (201) que celle sur laquelle est disposé le dispositif semi-conducteur (202).

# FIG. 1

# FIG. 2

102a

| Variable attenuator | Small-signal amplifier | Large-signal amplifier |

301        302        303

# FIG. 3

Occurrence of solder cracking

Increase in ambient temperature

Third threshold level ...... 120°C

Second threshold level ...... 115°C

First threshold level ...... 85°C

Temperature

RF energy output    Target value

Hardware control    Output is ON    Output is OFF

Variable attenuator (software control)    Output value

Time

# FIG. 4

Temperature

Fast temperature rise

Slow temperature rise

Third threshold level

Second threshold level {

First threshold level

One cycle=20ms

Time

# FIG. 5

201  202

203  106a

# FIG. 6

201  202  106a

203  204

# FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015099649 A1, WHIRLPOOL CO [US]
- JP 2017504158 A
- JP 4245191 A
- JP 2087929 A